# EUROPÄISCHE PATENTSCHRIFT

(11) **EP 1 781 566 B1**
(45) Veröffentlichungstag und Bekanntmachung des Hinweises auf die Patenterteilung: **14.03.2012**
(21) Anmeldenummer: 05726508.4
(22) Anmeldetag: 21.06.2005
(51) Int. Cl.: B81C 1/00, B81B 3/00

(54) **VERFAHREN ZUR ABSCHEIDUNG EINER ANTI-HAFTUNGSSCHICHT**
METHOD FOR DEPOSITING A NONSTICK COATING
PROCEDE DE DEPOT D'UNE COUCHE ANTIADHESIVE

(30) Priorität: 05.08.2004 DE 102004037902
(43) Veröffentlichungstag der Anmeldung: 09.05.2007
(73) Patentinhaber: ROBERT BOSCH GMBH, 70442 Stuttgart (DE)
(72) Erfinder: LÄRMER, Franz, 71263 Weil Der Stadt (DE); REICHENBACH, Ralf, 73732 Esslingen (DE)
(86) Internationale Anmeldenummer: PCT/EP2005/052862
(87) Internationale Veröffentlichungsnummer: WO 2006/015901

(56) Entgegenhaltungen:
- US-A1- 2003 064 149

## Beschreibung

### Stand der Technik

Die Erfindung betrifft ein Verfahren zur Abscheidung einer Anti-Haftungsschicht auf Oberflächen mikromechanischer Strukturen auf einem Substrat nach dem Oberbegriff des Anspruchs 1.

Bei der Herstellung oder Benutzung von mikromechanischen Strukturen wie beispielsweise in Sensor-Bauteilen besteht die Gefahr des sog. Haftens oder Klebenbleibens ("sticking"-Problem) der beweglichen Struktur an feststehenden Bereichen des Bauteils.

Bei einem nasschemischen Freilegen beweglicher Strukturen kann es zu einem Klebenbleiben der beweglichen Struktur an feststehenden Bereichen des Bauteils kommen, wenn nach der ätztechnischen Realisierung der beweglichen Struktur die Ätzflüssigkeit zunächst mit einer Spülflüssigkeit ersetzt und anschließend das Bauteil abgetrocknet wird. Während dieser Trocknungsphase zieht sich die Spülflüssigkeit zwischen der freistehenden Struktur und dem feststehenden Bereich des Bauteils, z. B. der Substratoberfläche unter der Struktur, immer mehr zusammen, und hierbei wird die freistehende Struktur aufgrund der Oberflächenspannung bzw. der Kapillarwirkung des Spülflüssigkeit-Tropfens zum feststehenden Bereich des Bauteils hingezogen. Kommen sie dabei miteinander in Kontakt, bleiben sie dann unerwünschterweise zusammen, wenn die zwischen ihnen wirkende Adhäsionskraft größer ist als die mechanische Rückstellkraft der freistehenden Struktur.

Um dieses Problem zu vermeiden, wird oft ein Trocknungsvorgang durchgeführt, bei dem keine oder nur eine vernachlässigbare Oberflächenspannung auftritt: Beim sogenannten "Über-Kritischer-Punkt-Trocknen" ("Super critical point drying") wird ein flüssiges Übergangsmedium, meistens CO₂, das die freistehenden Strukturen umgibt, in die Gasphase gebracht, ohne dabei die Phasengrenze "FlüssigGas" zu übertreten. Vielmehr werden Druck und Temperatur des CO₂-Fluids so eingestellt, dass das flüssige CO₂-Fluid zunächst in ein superkritisches CO₂-Fluid überführt und anschließend in den gasförmigen Zustand gebracht wird. Ein superkritisches Fluid ist per Definition in einem Zustand mit einer Temperatur größer oder gleich seiner kritischen Temperatur und mit einem Druck größer oder gleich seinem kritischem Druck. Die kritische Temperatur und der kritische Druck für CO₂ betragen 30,98 °C bzw. 74 bar (= 7,4 MPa). Typischerweise werden mikromechanische Strukturen durch Freiätzen einer aus Siliziumdioxid bestehenden Opferschicht mit Flusssäure freigelegt, anschließend mit Wasser und Aceton oder Isopropanol oder sonstige Alkohole gespült und mit einem Trocknungsgerät getrocknet, das als "Über-Kritischer-Punkt-Trockner" ("Super critical point drier", SCPD) bezeichnet wird. Bei diesem bekannten Verfahren lässt sich das Aceton sehr gut durch CO₂ verdrängen, woraufhin das CO₂ in dem "Über-Kritischer-Punkt-Trockner" zunächst in den superkritischen Zustand und anschließend in die gasförmige Phase überführt wird, wodurch dieser Prozess trockene, bewegliche Strukturen liefert. Jedoch ist die Verwendung eines solchen Prozesses in einer standardmäßigen CMOS-Umgebung ("complementary metal oxide semiconductor") nicht unproblematisch, da die Strukturen und damit die Wafer bis zu ihrer Trocknung im "Über-Kritischer-Punkt-Trockner" nicht trocken werden dürfen, da es ansonsten bereits zwischenzeitlich zu einem Ankleben der mikromechanischen Strukturen kommt. Bei einem verbreiteten Trockner einer bekannten Firma wird der Wafer zu diesem Zweck unter beispielsweise Isopropanol in einem Waferkorb eingepresst. Dieser lässt das superkritische Trocknen zu, jedoch nicht das Verdunsten des Alkohols. Trotzdem bestehen, vor allem bei einem vollautomatisierten Fertigungsprozess, gewisse Handling-Schwierigkeiten. Eine Beschichtung einer Anti-Haftungsschicht ist bei diesem Ablauf nicht vorgesehen.

Aus der DE 101 51 130 C1 ist ein Verfahren zum Herstellen eines mikromechanischen Bauelementes mit einer beweglichen Struktur bekannt, wobei zur Vermeidung des Stickens der beweglichen Struktur diese teilweise mit Fotolack fixiert wird, bevor die bewegliche Struktur freigeätzt wird. In einem Über-Kritischer-Punkt-Trockner wird der Fotolack mit einem organischen Lösungsmittel entfernt, welches anschließend durch CO₂ verdrängt und gelöst wird. Durch Erhöhen der Temperatur des Trockners über den kritischen Punkt des CO₂ wird das Bauteil getrocknet, ohne dass ein Sticken auftreten kann. Eine Abscheidung einer Anti-Haftungsschicht ist jedoch nicht vorgesehen. Durch dieses Verfahren kann also ein Sticken während der Herstellung der beweglichen Struktur ("release-stiction") vermieden werden, stellt aber keine Maßnahme gegen ein Anhaften der Strukturen während der späteren Benutzung dar ("in-use-stiction").

Eine mögliche Maßnahme gegen ein Sticken der Strukturen während der späteren Benutzung ist die Abscheidung einer Anti-Haftungsschicht auf die Oberfläche der mikromechanischen Strukturen. Grundsätzlich kann die Anti-Haftungsschicht ("Anti-Stiction-Coating", ASC) über einen Flüssig- oder Gasphasen-Prozess auf die Strukturen abgeschieden werden.

So wird aus der Schrift "Dichlorodimethylsilane as an Anti-Stiction Monolayer for MEMS: A Comparison to the Octadecyltrichlosilane Self-Assembled Monolayer", W. Ashurst et al., J. of MEMS, Vol. 10, No. 1, March 2001, p. 41-49, ein Verfahren zur Abscheidung einer Anti-Haftungsschicht vorgestellt, das dabei als Lösungsmittel Iso-octan mit darin gelöstem Precursormaterial, d. h. Vormaterial zur Schichtbildung, vorsieht. In der oben genannten Schrift werden als Anti-Haftungsschicht Monolagen aus Dichlorodimethylsilan (DDMS) und Monolagen aus Octadecyltrichlosilan (OTS) abgeschieden und deren Schichteigenschaften miteinander verglichen.

Weitere bekannte Alkylchlorosilane als mögliche Materialien einer Anti-Haftungsschicht sind beispielsweise Monochlorosilane, Perflouroctadecyltrichlorosilane oder Tridecaflouro-x-tetrahydrooctyltrichlorosilane, oder allgemein Alkylhalosilane. Aber auch nicht-chlorhaltige Dimethylaminosilane oder Alkene wie beispielsweise 1-Octadecene werden als Material für eine Anti-Haftungsschicht verwendet. Diese Materialien reagieren mit der entsprechend vorbehandelten Siliziumoberfläche der mikromechanischen Strukturen und bilden darauf Monolagen, also molekulare Einzelschichten mit einer nur wenige Angström dünnen Schichtdicke. Daneben werden auch Fullerene und Disilabutane zur Abscheidung von hochtemperaturbeständigen SiC-Monolagen als Anti-Haftungsschicht und als sog. "Anti-Wear-Coating" auf mikromechanischen Strukturen genutzt.

Eine solche Abscheidung aus der Flüssigphase ist jedoch bei bestimmten mikromechanischen Sensoren oder Mikrosystemen nicht ohne weiteres in den Fertigungsablauf integrierbar. Findet beispielsweise die Verkappung der Mikrosystemstruktur durch anodisches Bonden eines mit Kavernen versehenden Kappenwafers statt, darf sich auf den Bondflächen keine Anti-Haftungsschicht befinden. Durch die Existenz einer Anti-Haftungsschicht auf den Bondflächen wird die Festigkeit und Haltbarkeit der anodischen Verbindung und damit ihre Zuverlässigkeit erheblich beeinträchtigt. Auch kann bei einer Verkappung durch eine Dünnschichtkappen-Technologie wie beispielsweise SUMICAP ("Surface Micro-machined Encapsulation on Wafer level") die Anti-Haftungsschicht zu einer Inkompatibilität zu nachfolgenden Schichtabscheidungen und -strukturierungen sowie zu Kontaminationen der dafür benötigten Fertigungsanlagen führen. Ein weiterer Nachteil bei einer Abscheidung aus der Flüssigphase ist die bereits aus der Herstellung von freistehenden Strukturen bekannte Sticking-Problematik ("release-stiction") durch Kapillarkräfte.

Alternativ kann das abzuscheidende Material oder Precursormaterial auch über einen Gasphasenprozess den Strukturen zugeführt werden. So wird beispielsweise in US-2003/0099028 A1 vorgeschlagen, eine Anti-Haftungsschicht über einen PECVD-Prozess ("Plasma Enhanced Chemical Vapor Deposition") abzuscheiden. Gemäß der Lehre von US-2003/0099028 A1 wird nach der Abscheidung der Anti-Haftungsschicht an Bereichen wie Elektrodenoberflächen, die unbeschichtet bleiben sollen, über einen separaten, zusätzlich notwendigen Ätzschritt die Anti-Haftungsschicht wieder entfernt. Wird stattdessen die Abscheidung der Anti-Haftungsschicht nach der Verkappung durch Zugangslöcher, sog. Perforationslöcher, der Kappenschicht vorgenommen, besteht im allgemeinen das Problem einer nicht-konformen, d. h. nicht-uniformen Abscheidung. Das Material der Anti-Haftungsschicht wird möglicherweise die Zugangslöcher noch während der Abscheidung verschließen, bevor die Anti-Haftungsschicht vollständig auf alle relevanten mikromechanischen Strukturen aufgetragen wurde. Insbesondere ist es zu erwarten, dass tiefer liegende Strukturbereiche nicht mehr hinreichend beschichtet werden. Generell ist in der Gasphase nur ein geringer Massentransport möglich, so dass nur niedrige Abscheideraten erzielt werden können. Zudem ist die Auswahl des abzuscheidenden Materials oder Precursormaterials bei einer Abscheidung aus der Gasphase eingeschränkt.

Allgemein besteht überdies bei Verwendung von chlorhaltigen Materialien die Gefahr einer Bildung der Salzsäure (HCl), die die Fertigungsanlage oder Metallkontakte auf den Wafern angreifen und korrodieren kann bzw. auch zu einer sehr viel später einsetzenden Korrosion Anlass geben kann.

Aus der US 2003/0064149 A1 ist ein Verfahren zur Beschichtung einer mikromechanischen Vorrichtung bekannt, bei dem ein Beschichtungsmaterial in Kohlendioxid gelöst wird. Anschließend wird die so enthaltene Lösung auf die zu beschichtende Oberfläche aufgesprüht.

### Vorteile der Erfindung

Das erfindungsgemäße Verfahren zur Abscheidung einer Anti-Haftungsschicht auf Oberflächen mikromechanischer Strukturen hat den Vorteil, dass bei der Durchführung des Verfahrens keine Sticking-Probleme durch Kapillarkräfte des Lösungs-, Transport- oder Spülmediums auftreten und gleichzeitig eine konforme, d. h. uniforme Abscheidung auch durch kleine Kanäle oder Perforationslöcher ermöglicht wird.

Damit eignet sich das Verfahren auch zur Abscheidung einer Anti-Haftungsschicht nach der Verkappung der mikromechanischen Strukturen durch Zugangslöcher in der Kappenschicht.

Vorteilhafte Weiterbildungen des erfindungsgemäßen Verfahrens sind in den Unteransprüchen angegeben.

### Zeichnungen

Ausführungsbeispiele der Erfindung sind in den Zeichnungen dargestellt und in der nachfolgenden Beschreibung näher erläutert.

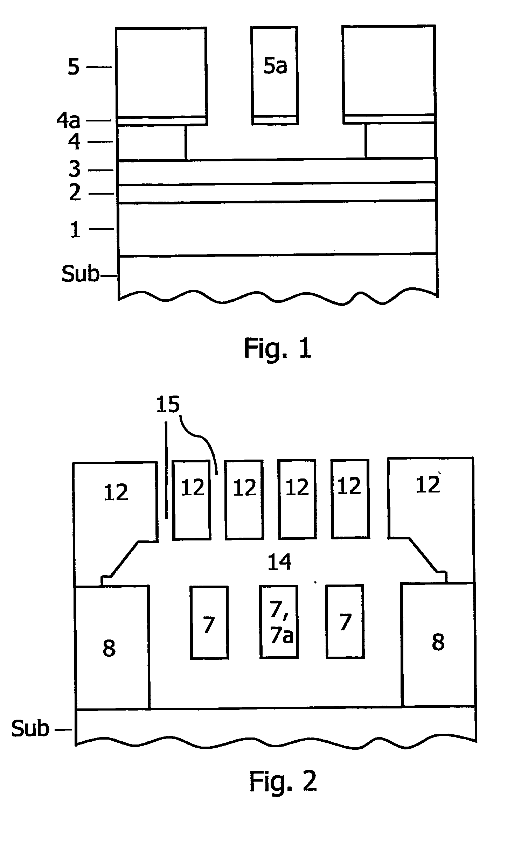

Es zeigen die Figuren 1 und 2 jeweils ein Beispiel von einer mikromechanischen Struktur auf einem Substrat im Schnitt, worauf die Abscheidung einer Anti-Haftungsschicht durchgeführt werden kann.

### Beschreibung der Ausführungsbeispiele

Das Prinzip des erfindungsgemäßen Verfahrens zeichnet sich vom Stand der Technik dadurch aus, dass unter Einsatz von superkritischem CO₂-Fluid als Lösungs- und Transportmedium das abzuscheidende Material oder Precursormaterial den Strukturen zugeführt wird. Die Abscheidung wird durch eine physikalische Zustandsänderung des CO₂-Fluids hervorgerufen.

In dem Ausführungsbeispiel wird beschrieben, wie die Abscheidung durch eine physikalische Zustandsänderung des CO₂-Fluids kontrolliert wird. In den Figuren 1 und 2 sind zwei Beispiele von mikromechanischen Strukturen auf einem Substrat Sub jeweils im Querschnitt dargestellt, worauf nun eine Abscheidung einer Anti-Haftungsschicht durchgeführt werden kann. Figur 1 zeigt ein Substrat Sub, auf dem aufeinanderfolgend eine erste Isolationsschicht 1, eine Leitschicht 2, eine zweite Isolationsschicht 3, eine Opferschicht 4, eine Schutzschicht 4a und eine strukturierte Schicht 5 mit einer mikromechanischen Struktur 5a vorgesehen ist. Dagegen zeigt Figur 2 auf einem Substrat Sub Sensorelemente 7 mit einer beweglichen, mikromechanischen Struktur 7a innerhalb eines Hohlraumes bzw. einer Kaverne 14. Der Hohlraum wird räumlich durch die angrenzenden Oberflächen des Substrats Sub, der Stützstrukturen 8 und einer Kappenschicht 12 begrenzt. Nach der Herstellung und Verkappung der Sensorelemente 7 aus typischerweise Silizium werden in der Kappenschicht 12 nachträglich Zugangskanäle 15, sog. Perforationslöcher, strukturiert. Wahlweise können die Löcher bereits in der Kappenschicht 12 vorhanden sein, so dass eine nachträgliche Strukturierung nicht notwendig ist. Solche Perforationslöcher sind oft dafür vorgesehen, um die Atmosphäre in der Kaverne 14 nachträglich zu evakuieren und anschließend wieder zu verschließen. Diese Perforationslöcher können für das erfindungsgemäße Verfahren bei der Zufuhr des CO₂-Fluids verwendet werden. Als Transport- und Lösungsmedium wird erfindungsgemäß superkritisches CO₂-Fluid eingesetzt. Vor der Zuführung des CO₂-Fluids zu den mikromechanischen Strukturen wird dem CO₂-Fluid das abzuscheidende Material beigemischt.

Sofern das abzuscheidende Material aus unpolaren Molekülen besteht, löst sich das Material direkt im CO₂-Fluid. Bei einem Material aus im CO₂-Fluid schlecht löslichen polaren Molekülen wird dem CO₂-Fluid Hilfslösungs- oder Netzmittel zugesetzt. Beispielhafte Stoffe aus polaren Molekülen sind Wasser, Dimethylsulfoxid (DMSO), Acetonitril, Methanol oder Phenol, während Stoffe wie Benzol, Cyclohexan, Tetrachlorethylen oder Kohlenwasserstoff aus unpolaren Molekülen bestehen. Mit Hilfslösungsmittel und in sogenannten Mikroemulsionen aus CO₂/Wasser/Netzmittel können auch hochpolare Moleküle und Ionen in großen Volumenanteilen in superkritischem CO₂-Fluid gelöst und transportiert werden. Durch den Zusatz von Hilfslösungs- oder Netzmittel zum CO₂ kommt ein viel größeres Spektrum an nutzbaren Chemikalien für die Anti-Haftungsschicht in Betracht. Diese Netzmittel werden auch als Surfactanten (=Surface active agents) bezeichnet. Häufig findet der Surfactant AOT (Natrium-dioctylsulfosuccinat) Anwendung. Hierbei ist keine heftige chemische Reaktion, beispielsweise zwischen Chlor und der zu beschichtenden Oberfläche eine Voraussetzung für eine Schichtabscheidung, vielmehr genügt eine gewisse Affinität der abzuscheidenden Moleküle zur Siliziumoberfläche.

Das superkritische CO₂-Fluid mit darin gelöstem Abscheidungsmaterial wird durch die Zugangslöcher den mikromechanischen Strukturen zugeführt. Durch Erhöhung von Temperatur bzw. Druck des CO₂-Fluids über die kritische Temperatur bzw. über den kritischen Druck hinaus erhält man ein CO₂-Fluid mit einer vernachlässigbar geringen Oberflächenspannung und verbesserten Lösungseigenschaften für die abzuscheidenden Moleküle. Dies gilt sowohl für den Fall mit als auch ohne Hilfslösungsmittel. Aufgrund der geringen Oberflächenspannung kann dieses Gemisch bis in die kleinsten Strukturen mit den größten Topographien und engsten Zugängen transportiert werden.

Die Abscheidung des Materials im CO₂-Fluid wird durch eine Temperatur- bzw. Druckminderung des Fluids erzielt. Bei der Minderung des Drucks reduziert sich die Löslichkeit des Materials im CO₂-Fluid, d. h. die Menge an Materialien, die das Fluid lösen kann, nimmt ab. Daraus resultiert eine Abscheidung des Materials aus dem CO₂-Fluid und führt so zur Bildung der Anti-Haftungsschicht auf der Oberfläche der mikromechanischen Strukturen.

Durch eine genaue Kontrolle von Druck und Temperatur kann die Abscheidung langsam oder schlagartig erfolgen. Die Löslichkeit des Materials oder Precursormaterials im superkritischen CO₂-Fluid wird durch kontrollierte Druck- und/oder Temperaturminderung nur soweit verringert, bis die entsprechende Abscheidungsmenge oder Schichtdicke erreicht ist. Alternativ kann die Druck- und/oder Temperaturminderung soweit erfolgen, dass das CO₂-Fluid von der superkritischen in die flüssige Phase überführt wird. Beim direkten Überschreiten der Phasengrenze wird dann schlagartig abgeschieden. In beiden Fällen beginnt also die Abscheidung im Gegensatz zu einem Gasphasenprozess nicht mit dem Vorhandensein des Reaktionsmediums, sondern zu einem Zeitpunkt, wenn bereits ausreichend Reaktionsmedium an allen relevanten zu beschichtenden Stellen vorhanden ist. Der genaue Zeitpunkt der Abscheidung lässt sich also durch die Einstellung von Druck und Temperatur bestimmen.

Beiden Ausführungsbeispiel kann das superkritische CO₂-Fluid den mikromechanischen Strukturen in einer Kaverne nach deren Verkappung über Zugangskanäle oder Perforationslöcher zugeführt werden. Auch eignet es sich, um die Anti-Haftungsschicht auf Oberflächen von langen, schmalen Kanälen oder auf dem Substrat zugewandten Oberflächen von Strukturen abzuscheiden.

## Patentansprüche

1. Verfahren zur Abscheidung einer Anti-Haftungsschicht auf Oberflächen mikromechanischer Strukturen (5a; 7a) auf einem Substrat (Sub), wobei das abzuscheidende Material oder Precursormaterial in einem Lösungs- und Transportmedium den Strukturen (5a; 7a) zugeführt wird, wobei bei der Zufuhr als Lösungs- und Transportmedium superkritisches CO₂-Fluid vorliegt und die Abscheidung des Materials oder Precursormaterials durch eine physikalische Zustandsänderung des CO₂-Fluids hervorgerufen wird, wobei die physikalische Zustandsänderung des CO₂-Fluids durch eine Temperatur- und/oder Druckminderung des CO₂-Fluids erzielt wird, **dadurch gekennzeichnet, dass** durch die Temperatur- und/oder Druckminderung das superkritische CO₂-Fluid in die flüssige Phase überführt wird.

2. Verfahren nach Anspruch 1, **dadurch gekennzeichnet, dass** durch die Temperatur- und/oder Druckminderung die Löslichkeit des Materials oder Precursormaterials im superkritischen CO₂-Fluid verringert wird.

3. Verfahren nach einem der vorhergehenden Ansprüche, **dadurch gekennzeichnet, dass** dem superkritischen CO₂-Fluid Hilfslösungsmittel oder Netzmittel wie beispielsweise Natrium-dioctylsulfosuccinat (AOT) zugesetzt wird.

4. Verfahren nach einem der vorhergehenden Ansprüche, **dadurch gekennzeichnet, dass** das superkritische CO₂-Fluid den mikromechanischen Strukturen (5a; 7a) in einer Kaverne (14) nach deren Verkappung über Zugangskanäle (15) oder Perforationslöcher zugeführt wird.

5. Verfahren nach einem der vorhergehenden Ansprüche, **dadurch gekennzeichnet, dass** die Anti-Haftungsschicht auf Oberflächen von langen, schmalen Kanälen oder auf dem Substrat (Sub) zugewandten Oberflächen von Strukturen (5a; 7a) abgeschieden wird.

## Claims

1. Process for depositing an antiadhesion layer on surfaces of micromechanical structures (5a; 7a) on a substrate (Sub), wherein the material to be deposited or precursor material is supplied in a solvent or transport medium to the structures (5a; 7a), wherein supercritical CO₂ fluid is present as solvent and transport medium in the supply and the deposition of the material or precursor material is brought about by a physical change in state of the CO₂ fluid, wherein the physical change in state of the CO₂ fluid is achieved by means of a reduction in the temperature and/or pressure of the CO₂ fluid, **characterized in that** the supercritical CO₂ fluid is converted into the liquid phase by the reduction in the temperature and/or pressure.

2. Process according to Claim 1, **characterized in that** the solubility of the material or precursor material in the supercritical CO₂ fluid is reduced by the reduction in the temperature and/or pressure.

3. Process according to either of the preceding claims, **characterized in that** auxiliary solvent or wetting agent such as sodium dioctylsulphosuccinate (AOT) is added to the supercritical CO₂ fluid.

4. Process according to any of the preceding claims, **characterized in that** the supercritical CO₂ fluid is supplied to the micromechanical structures (5a; 7a) in a cavity (14) via access channels (15) or perforation holes after capping of the cavity (14).

5. Process according to any of the preceding claims, **characterized in that** the antiadhesion layer is deposited on surfaces of long, narrow channels or on surfaces of structures (5a; 7a) facing the substrate (Sub).

## Revendications

1. Procédé de dépôt d'une couche antiadhésive sur la surface de structures micromécaniques (5a; 7a) d'un substrat (Sub),
le matériau à déposer ou un matériau précurseur étant apporté aux structures (5a; 7a) dans un fluide de dissolution et de transport, du CO₂ hypercritique fluide étant utilisé comme fluide de dissolution et de transport lors de l'amenée et le dépôt du matériau ou du matériau précurseur étant provoqué par une modification de l'état physique du CO₂ fluide,
la modification de l'état physique du CO₂ fluide étant obtenue par une diminution de la température et/ou de la pression du CO₂ fluide,
**caractérisé en ce que**
le CO₂ hypercritique fluide est amené en phase liquide par abaissement de température et/ou de pression.

2. Procédé selon la revendication 1, **caractérisé en ce que** la diminution de température et/ou de pression diminue la solubilité du matériau ou du matériau précurseur dans le CO₂ hypercritique fluide.

3. Procédé selon l'une des revendications précédentes, **caractérisé en ce que** des adjuvants de solubilisation ou des agents mouillants, par exemple le dioctylsulfosuccinate de sodium (AOT), sont ajoutés au CO₂ hypercritique fluide.

4. Procédé selon l'une des revendications précédentes, **caractérisé en ce que** le CO₂ hypercritique fluide est amené sur les structures micromécaniques (5a; 7a) dans une caverne (14) par des canaux d'accès (15) ou des perforations après la fermeture de la caverne.

5. Procédé selon l'une des revendications précédentes, **caractérisé en ce que** la couche antiadhésive est déposée sur la surface de canaux longs et étroits ou sur la surface de structures (5a; 7a) tournée vers le substrat (Sub).
